# FASCICULE DE BREVET EUROPEEN

(11) **EP 2 568 788 B1**
(45) Date de publication et mention de la délivrance du brevet: **17.05.2017**
(21) Numéro de dépôt: 12305976.8
(22) Date de dépôt: 06.08.2012
(51) Int. Cl.: H05K 7/14

(54) **Dispositif et procédé de contrôle d'appareil ou d'installation électrique, installation électrique comportant un tel dispositif**
Vorrichtung und Verfahren zur Kontrolle eines elektrischen Geräts oder einer elektrischen Anlage, und eine solche Vorrichtung umfassende elektrische Anlage
Device and method for monitoring an electric apparatus or installation, electric installation comprising one such device

(30) Priorité: 08.09.2011 FR 1102729
(43) Date de publication de la demande: 13.03.2013
(73) Titulaire: Schneider Electric Industries SAS, 92500 Rueil-Malmaison (FR)
(72) Inventeur: Lebeau, Bernard, 38050 Grenoble Cedex 9 (FR); Dalbe, Michel, 38050 Grenoble Cedex 9 (FR); Vernay, Marc, 38050 Grenoble Cedex 9 (FR); Suptitz, Eric, 38050 Grenoble Cedex 9 (FR); Cruchet, Victor, 38050 Grenoble Cedex 9 (FR)
(74) Mandataire: Tripodi, Paul

(56) Documents cités:
- EP-A1- 0 952 523
- EP-A2- 1 881 574
- WO-A1-92/04813
- WO-A1-2009/118028
- DE-A1- 10 131 172
- DE-A1-102005 025 703
- US-A- 5 099 449
- US-A1- 2004 201 972

## Description

### DOMAINE TECHNIQUE

L'invention concerne un dispositif de contrôle d'appareil ou d'installation électrique comportant au moins un module de contrôle comprenant un connecteur pour connecter au moins une entrée ou une sortie, ledit module de contrôle comportant au moins un circuit interrupteur interne connecté à ladite au moins une entrée ou sortie.

L'invention concerne aussi une installation électrique comportant au moins un tableau ou une armoire électrique, au moins un appareil électrique, au moins un module de contrôle.

L'invention concerne aussi un procédé de contrôle d'appareil ou d'installation électrique comportant au moins un module de contrôle, au moins un concentrateur, et un superviseur ou un ordinateur local.

### ETAT DE LA TECHNIQUE

Les dispositifs de contrôle d'appareil ou d'installation électrique de l'art antérieur comportent des concentrateurs avec des borniers à vis disposés dans des tableaux électriques. Cela implique un câblage fil à fil entre le concentrateur et des appareils électriques complexes. Le câblage fil à fil complexe est long de part l'éloignement possible dans l'armoire entre le concentrateur et les appareils électriques à superviser ou à commander. Dans ces dispositifs, des erreurs de câblage sont fréquentes à cause de la densité de câblage et la difficulté à visualiser la structure de l'armoire.

La demande de brevet EP1881574 décrit une partie mobile d'un répartiteur d'alimentation de puissance électrique destinée à connecter des contacts électrique à un bus de communication. Cependant les figures de cette demande ne montrent que des liaisons filaires qui ne simplifient pas le câblage.Le document US 2004/201972 A1 décrit un diapositif de contrôle selon le préambule de la revendication 1.

### EXPOSE DE L'INVENTION

L'invention a pour but un dispositif et un procédé de contrôle permettant un câblage rapide et fiable d'une installation électrique.

Un dispositif de contrôle d'appareil ou d'installation électrique selon l'invention comportant au moins un module de contrôle comprenant un connecteur pour connecter au moins une entrée ou une sortie, ledit module de contrôle comportant au moins un circuit interrupteur interne connecté à ladite au moins une entrée ou sortie, comporte un concentrateur comportant des connecteurs d'entrées-sorties pour connecter des entrées-sorties audit au moins un module de contrôle, des moyens de traitement pour traiter des informations desdites entrées-sorties et un circuit de communication pour communiquer des données relatives audites entrées-sorties, ledit circuit de traitement pouvant traiter ou reporter des états de chaque entrées-sorties dudit concentrateur, lesdits connecteurs d'entrées-sorties dudit concentrateur étant destinés à être connectés à un connecteur d'au moins un module de contrôle par une liaison comportant une ligne de référence, une ligne d'alimentation, et au moins une ligne d'entrée ou de sortie.

De préférence, un connecteur dudit module de contrôle et les connecteurs dudit concentrateur sont des connecteurs standards de même type,
Selon un mode réalisation préférentiel, le dispositif comporte au moins une liaison électrique entre un connecteur d'au moins un module de contrôle et un connecteur d'entrées-sorties dudit concentrateur, ladite liaison comportant une ligne de référence, une ligne d'alimentation, une première ligne d'entrée d'un connecteur de concentrateur, une seconde ligne d'entrée dudit connecteur de concentrateur, et une ligne de sortie dudit connecteur de concentreur. Selon l'invention, au moins un module de contrôle est associé à un appareil électrique modulaire pour transmettre des états dudit appareil électrique vers le concentrateur ou pour recevoir des commandes d'actionnement pour actionner ledit appareil électrique depuis ledit concentrateur.

Avantageusement, au moins un module de contrôle est un module de contrôle autonome pour transmettre des états ou des informations d'état de capteurs de grandeurs physiques internes ou externes audit module.

Dans un mode de réalisation particulier, ledit module de contrôle autonome comporte des moyens de mesure et de calcul d'énergie électrique pour émettre des impulsions représentatives d'énergie électrique, lesdites impulsions étant réalisées par la fermeture d'un circuit entre une ligne commune ou d'alimentation et une ligne d'entrée d'un connecteur d'entrées-sorties dudit concentrateur.

Avantageusement, ledit circuit de traitement du concentrateur reçoit des impulsions et convertit un nombre d'impulsions par unité de temps en valeur d'énergie électrique à transmettre sur le réseau.

De préférence, le concentrateur a une forme allongée et est destiné à être intercalé entre des rangées de supports en forme de rail pour appareillages modulaires.

De préférence, il comprend des moyens supports pour supporter ledit concentrateur, lesdits moyens supports étant destinés à être fixés sur des rails de support d'appareillage électrique modulaire.

Avantageusement, le concentrateur comporte des moyens d'adressage et des moyens d'identification de chaque entrée sortie des connecteurs du concentrateur.

Une installation électrique selon l'invention comportant au moins un tableau ou une armoire électrique, au moins un appareil électrique, au moins un module de contrôle, comprend au moins un dispositif de contrôle tel que défini ci-dessus comportant au moins un concentrateur sur lequel sont connectés des modules de contrôle.

De préférence, l'installation comprend un superviseur connecté en réseau avec au moins un concentrateur.

Un procédé de contrôle d'appareil ou d'installation électrique selon l'invention comportant au moins un module de contrôle, au moins un concentrateur, et un superviseur ou un ordinateur local, comporte une phase de test comportant :
- l'actionnement d'un module de contrôle,
- l'élaboration et l'envoi d'une trame de communication par le concentrateur comportant l'identification
   - de l'adresse du concentrateur,
   - d'un bloc contact du concentrateur,
   - d'une l'entrée ou d'une sortie dudit bloc contact, et
   - de l'état ou du changement d'état de ladite entrée ou sortie,
   - l'association dans le superviseur ou ordinateur local de la dite entrée ou sortie actionnée ou du bloc contact correspondant à un type d'appareil préenregistré dans une table dudit superviseur ou ordinateur local, et
- la mémorisation de l'actionnement du module de contrôle et d'attributs d'identification.

Selon une première variante, le procédé comporte l'édition de rapport de test comprenant l'ensemble des actionnements des modules de contrôle et des attributs d'identification.

Selon une première variante, le procédé comporte l'édition de schémas électriques comprenant l'ensemble des actionnements des modules de contrôle et des attributs d'identification.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma d'un dispositif de contrôle d'appareil ou d'installation électrique selon un mode de réalisation de l'invention ;
- la figure 2 représente un dispositif de contrôle selon un mode de réalisation de l'invention montrant la disposition de modules ;
- la figure 3 représente un schéma global d'une installation comprenant un dispositif selon mode de réalisation de l'invention ;
- la figure 4 représente une installation comprenant des dispositifs contrôle selon un mode de réalisation de l'invention ;
- la figure 5 représente une vue d'un concentrateur d'un dispositif de contrôle d'appareil ou d'installation électrique selon un mode de réalisation de l'invention ;
- la figure 6 représente une vue d'un dispositif de contrôle selon un mode de réalisation de l'invention ;
- la figure 7 représente un organigramme d'un procédé selon l'invention.

### DESCRIPTION DETAILLEE DE MODES DE REALISATION PREFERES

Le dispositif de contrôle d'appareil ou d'installation électrique comporte au moins un module de contrôle comprenant un connecteur pour connecter au moins une entrée ou une sortie, ledit module de contrôle comportant au moins un circuit interrupteur interne connecté à la dite au moins une entrée ou sortie.

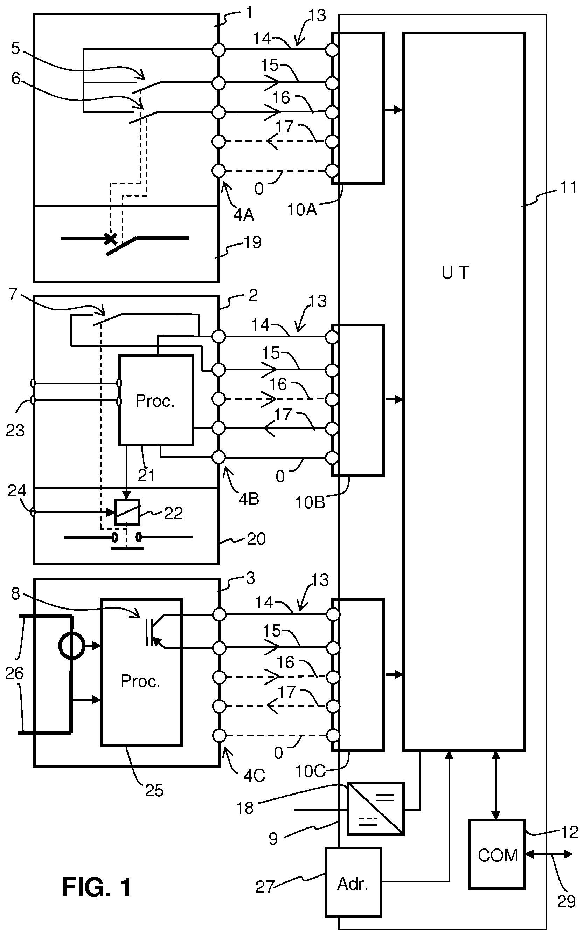

Dans le mode réalisation de la figure 1, des modules de contrôle 1, 2 et 3 comportent des connecteurs respectivement 4A, 4B, 4C connectés en interne à des circuits interrupteurs tels que des contacts électriques 5, 6, 7 ou des semi-conducteurs 8 pouvant ouvrir ou fermé un circuit électrique. Le dispositif selon un mode réalisation de l'invention de la figure 1, comporte un concentrateur 9 comportant des connecteurs 10A, 10B, 10C d'entrées-sorties pour connecter des entrées-sorties audits module de contrôle 1, 2, 3. Un circuit de traitement 11 traite des informations desdites entrées-sorties et un circuit de communication 12 communique des données relatives aux entrées-sorties. Ainsi, le circuit de traitement peut traiter ou reporter des états de chaque entrées-sorties du concentrateur. Les connecteurs d'entrées-sorties 10A, 10B, 10C du concentrateur 9 sont destinés à être connectés à des connecteurs 4A, 4B, 4C d'au moins un module de contrôle par une liaison comportant une ligne de référence 0, une ligne d'alimentation 14, et au moins une ligne d'entrée 14,15 ou de sortie 16.

Avantageusement, les connecteurs 4A, 4B ou 4C des modules 1, 2, 3 et les connecteurs 10A, 10B, 10C du concentrateur 9 sont des connecteurs standards de même type. Ainsi, Le concentrateur et les modules comportent le même type de connecteur. Ils sont reliés entre eux par des liaisons ou des cordons de même type permettant un câblage rapide homogène. Le dispositif de contrôle comporte des liaisons électriques 13 connectées entre les connecteurs 4A, 4B ou 4C des modules 1, 2, 3 et les connecteurs 10A, 10B, 10C d'entrées-sorties du concentrateur 9. La liaison 13 comprend une ligne de référence 0, une ligne d'alimentation 14, une première ligne de d'entrée 15 d'un connecteur de concentrateur, une seconde ligne d'entrée 16 du connecteur de concentrateur, et une ligne de sortie 17 du connecteur de concentreur 10A. Les conducteurs de cette ligne sont exprimés en prenant les connecteurs du concentrateur comme référence.

En prenant le connecteur des modules de contrôle comme référence, les liaisons entre les connecteurs comprennent de préférence deux sorties 15 et 16 donnant des informations depuis les module vers le concentrateur, une entrée 17 donnant une information depuis le concentrateur vers un module, et deux lignes d'alimentation 0 et 14 dont une sert de référence 0. De préférence, l'alimentation entre les deux lignes est de 24V continu. L'alimentation est fournie par un circuit l'alimentation 18 alimentant le circuit de traitement et l'ensemble des connecteurs du concentrateur.

Les modules de contrôle sont associés à un appareil électrique modulaire 19 pour transmettre des états dudit appareil électrique vers le concentrateur ou pour recevoir des commandes d'actionnement pour actionner ledit appareil électrique depuis ledit concentrateur. Le module 1 est associé à un appareil électrique 19 tel qu'un disjoncteur pour transmettre des signaux représentatifs de l'état ouvert ou fermé ou de l'état déclenchement sur défaut électrique. Dans ce cas, l'interrupteur 5 en liaison mécanique avec le déclencheur du disjoncteur peut transmettre sur le conducteur 15 l'information d'ouverture sur défaut électrique lorsqu'il est fermé, et l'interrupteur 6 en liaison mécanique avec les contacts électriques du disjoncteur peut transmettre sur le conducteur 16 l'information d'ouverture sur commande manuelle ou automatique lorsqu'il est fermé. Le module 2 est associé à un appareil électrique 20 tel qu'un contacteur ou un relai pour transmettre des signaux représentatifs de l'état ouvert ou fermé ou pour recevoir des ordres de commande. L'interrupteur 7 en liaison mécanique avec des contacts électriques du contacteur peut transmettre sur le conducteur 15 l'information d'ouverture des contacts principaux. Sur la ligne 17 de la liaison un ordre de commande peut transiter par le connecteur 10 depuis le concentrateur pour commander l'ouverture ou la fermeture du contacteur. Un circuit de contrôle local 21 traite l'ordre de commande pour commander la bobine 22 du contacteur. Des ordres le commande de la bobine peuvent aussi arrivés sur la bobine 22 ou sur le circuit de contrôle local 21 à travers des bornes 23 ou 24. Ainsi, les modules de contrôle peuvent être des modules auxiliaires de disjoncteurs ou interrupteurs, des dispositifs modulaires de télécommande de contacteurs, relais, télé-rupteurs, interrupteurs commandés ou disjoncteur commandés.

Les modules de contrôle peuvent être autonomes pour transmettre des états ou des informations d'état de capteurs de grandeurs physiques internes ou externes audit module. Le module de contrôle autonome 3 comporte des moyens de mesure et de calcul d'énergie électrique pour émettre des impulsions représentatives d'énergie électrique. Dans ce cas, les impulsions sont réalisées par la fermeture d'un circuit entre la ligne commune 0 ou d'alimentation 14 et une ligne d'entrée 15, 16 d'un connecteur 10C d'entrées-sorties concentrateur 9. Dans le mode de réalisation de la figure 1, à chaque impulsion, un semi-conducteur 8 ferme le circuit interrupteur entre les lignes 14 et 15. La durée entre chaque début d'impulsion est représentative de l'énergie électrique distribuée par des conducteurs électriques 26, un circuit de traitement local 25 reçoit des signaux de courants et de tension des conducteurs 26 et calcule l'énergie électrique pour déterminer la durée ou la fréquence des impulsions. Un tel module peut aussi transmettre d'autres grandeurs électriques telles que le courant, la tension, la phase, la puissance ou le facteur de puissance. Le module de contrôle autonome 3 peut avoir deux canaux de mesure et transmettre des premières impulsions représentatives d'une première énergie électrique sur la ligne 15 et des secondes impulsions représentatives d'une seconde énergie électrique sur la ligne 16. Dans ce cas, un second semi-conducteur est connecté entre la ligne 14 et la ligne 16. Le circuit de traitement 11 du concentrateur reçoit les impulsions et converti un nombre d'impulsions par unité de temps en valeur d'énergie électrique. Les valeurs de conversion sont fournies par paramétrage depuis le superviseur ou un ordinateur local.

Les modules de contrôle autonomes peuvent être aussi des capteurs de grandeur physique telle que la lumière ou la température ou des capteurs de position.

Le concentrateur de la figure 1 comporte des moyens d'adressage 27 pour différencier chaque concentrateur connecté à un même superviseur. De plus chaque entrée sortie des connecteurs 10A, 10B, 10C du concentrateur sont identifiés pour être envoyées dans les trames de communication.

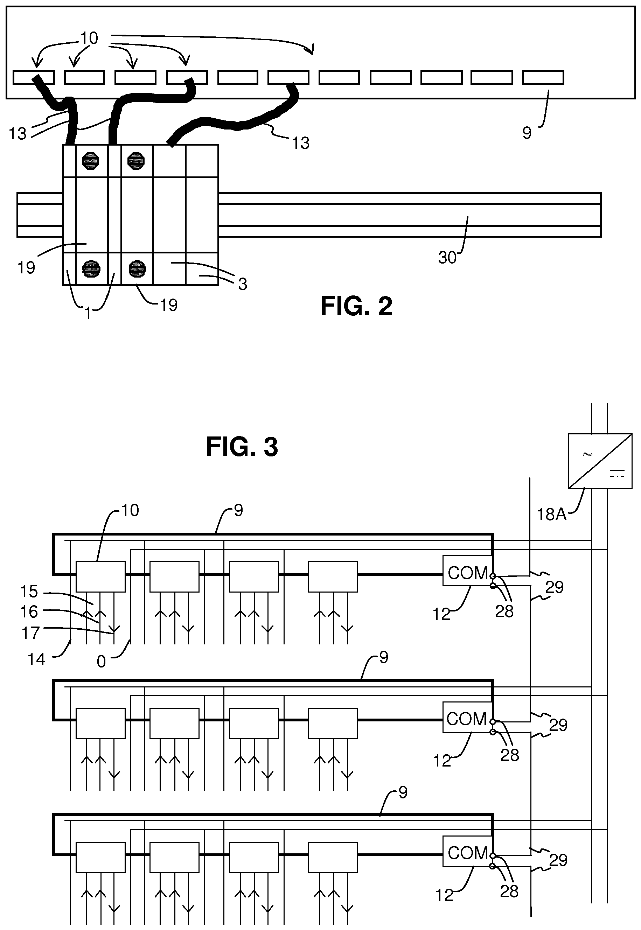

La figure 2 représente un dispositif de contrôle selon un mode de réalisation de l'invention montrant la disposition des modules et un concentrateur. Les modules sont disposés sur un rail. Le concentrateur est disposé aligné en parallèle par rapport aux modules disposés sur le rail. Les connecteurs des modules et du concentrateur de préférence sensiblement en vis sa vis pour réduire les longueurs des câbles des liaisons 13 et la densité de câblage des installations.

La figure 3 représente un schéma global d'une installation comprenant un dispositif avec 3 modules concentrateurs 9. Sur ce schéma, les concentrateurs sont alimentés par une alimentation 18A centrale commune à plusieurs concentrateurs. Avantageusement cette alimentation est une alimentation continue ou redressée de 24 volts. L'alimentation est distribuée sur les connecteurs des concentrateurs pour alimenter ou polariser les modules de contrôle. Sur cette figure, les circuits de communication 12 de chaque concentrateur 9 comportent deux connecteurs de communication 28 pour permettre un câblage 29 en chaine des circuits de communication. Ces connecteurs sont par exemple du type RJ45.

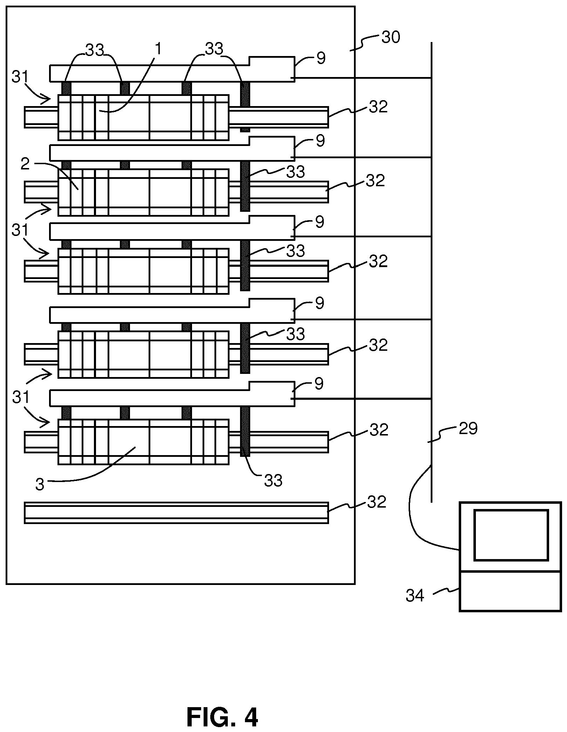

La figure 4 représente une installation comprenant des dispositifs de contrôle selon un mode de réalisation de l'invention. L'installation comprend un tableau ou une armoire électrique 30 recevant des appareils électriques modulaires 31 disposés sur des rails supports 32. Les concentrateurs 9 ont une forme allongée et sont destinés à être intercalés entre des rangées de supports en forme de rail pour appareillage modulaires. Les modules de contrôle 1, 2, 3 sont aussi disposés sur les rails 32 est connectés aux concentrateurs. Les concentrateurs sont de préférence maintenus par des supports mécaniques 33 fixés sur les rails 32. L'installation électrique comporte aussi un superviseur 34 connecté en réseau 29 avec les modules concentrateur 9.

Le concentrateur 9 communique des états et des caractéristiques des entrée/sortie des appareils électriques sur des lignes ou le réseau de communication 29 par exemple de type ModBus SL ou autre (TCP, LON, KNX, Ethernet, CAN...) au superviseur 34. Le concentrateur peut aussi comporter un port USB pour être directement relié un ordinateur portable et transmettre des informations des modules comme sur le réseau. Ainsi, des tests des connexions des connecteurs peuvent être réalisés sur un ordinateur portable branché sur la connexion réseau d'un concentrateur 9. De cette manière, les tests peuvent être faits même sans accès physiques aux connecteurs des modules de contrôle.

Sur cette figure 4, les appareils modulaires sont installés dans une armoire électrique sur plusieurs rangées sur des rails symétriques avec les modules de contrôle. Un concentrateur 9 est disposé au dessus de chaque ligne d'appareillages et de modules de contrôle pour être au plus proche et limiter les longueurs de câble.

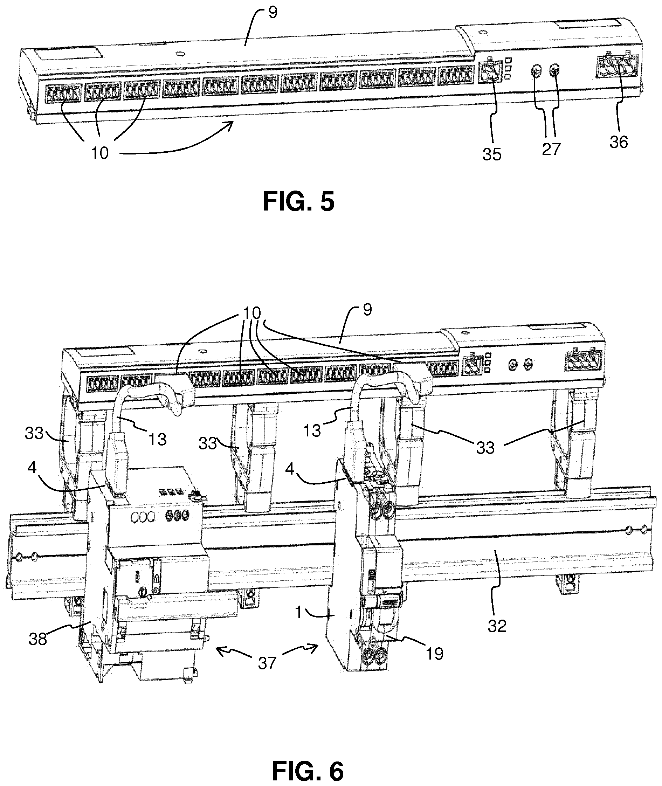

La figure 5 représente une vue d'un concentrateur 9 selon un mode de réalisation de l'invention. Ce concentrateur de forme allongée comporte 11 connecteurs 10 d'entrée sortie pour pouvoir connecter 11 modules de contrôle par des liaisons standardisées. Il comporte un connecteur d'alimentation 35 de type 24 volts, des moyens d'adressage 27 tels que des roues codeuses pour attribuer une adresse différente à chaque concentrateurs, et un connecteur de communication réseau 36.

La figure 6 représente une vue complète d'un dispositif de contrôle selon un mode de réalisation de l'invention. Sur cette figure, le dispositif comprend des supports 33 pour supporter et fixer le concentrateur 9. Les supports 33 sont destinés à être fixés sur des rails 32 de support d'appareillage électrique modulaires. Dans ce cas, les supports 33 ont une forme de pieds bracelets qui permettent de le maintenir ainsi que de faire office de goulotte pour des câbles. Les supports en forme de pieds bracelets se fixent sur tous types de rails en aluminium ou acier, simple ou double profil à l'aide d'un accessoire.

Le dispositif de contrôle selon des modes de réalisation de l'invention permet à un électricien de simplifier le câblage, d'éviter les risques d'erreur, d'éviter des passages de fils complexes dans des goulottes. L'électricien n'a pas besoin de programmer le concentrateur, il lui suffit juste de d'attribuer l'adresse du concentrateur en agissant sur deux commutateurs et de connecter les liaisons 13 entre le concentrateur et les modules de contrôle 1, 2, 3, 37. Le câblage peut se faire sans schéma électrique puisque les attributions des fonctions peuvent être faites plus tard dans le superviseur par le choix dans des tables prédéfinies. De plus, un schéma électrique de câblage peut être généré automatiquement après attribution des fonctions.

La figure 6 montre des liaisons 13 assez courtes pour limiter la quantité de câblage. Ses liaisons sont réalisées par des câbles standardisés. Les câbles peuvent aussi avoir d'autres longueurs pour connecter des modules de contrôle à des concentrateurs plus éloignés ou sur d'autres rangées. Par exemple, le concentrateur peut être monté horizontalement ou verticalement en gaine par exemple afin de pouvoir distribuer plusieurs rangées lorsque le nombre de modules de contrôle est faible par rapport au nombre d'appareils électrique. De préférence, les prises des câbles sont surmoulées avec une enveloppe isolante de manière à garantir l'isolement et les lignes de fuites normalisées entre leurs connexions et d'autres connexions d'appareillages électrique.

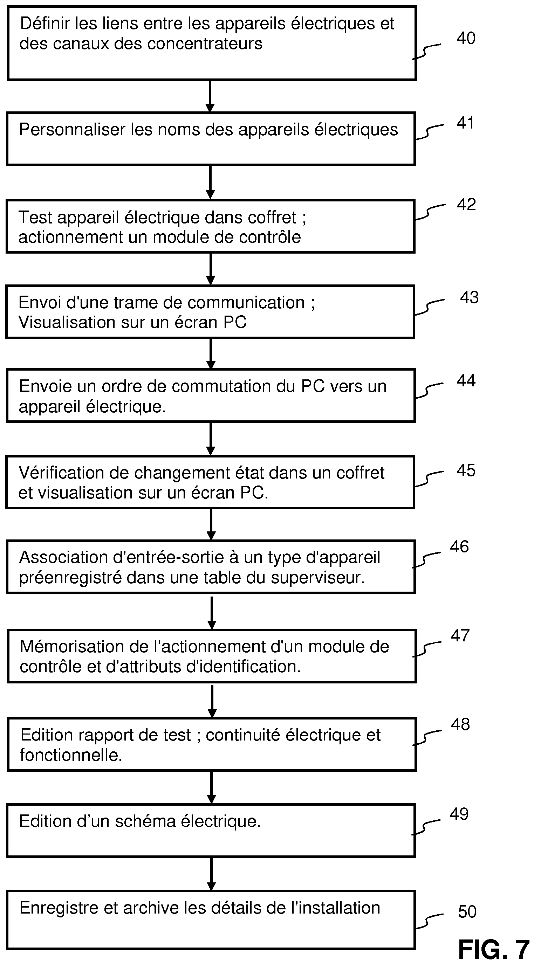

La figure 7 représente un organigramme d'un procédé selon l'invention. Le procédé de contrôle d'appareil ou d'installation électrique comportant au moins un module de contrôle, au moins un concentrateur, et un superviseur, comporte une phase de test. Dans cette phase de test, une étape 40 initialise la définition de liens entre des modules de contrôle et/ou des appareils électriques associés aux modules de contrôle et des canaux des concentrateurs matérialisés par des connecteurs d'entrée-sorties 10. Une étape 41 personnalise les noms des appareils électriques et les modules de contrôle.

Lors du test des appareils électriques et des modules de contrôle, l'actionnement des modules est réalisé à une étape 42. Puis étape 43 effectue l'élaboration et l'envoi d'une trame de communication par le concentrateur comportant l'identification de l'adresse du concentrateur, d'un bloc contact du concentrateur, d'une entrée ou d'une sortie dudit bloc contact, et de l'état ou du changement d'état de ladite entrée ou sortie. Des informations de la trame sont alors visualisées sur un écran d'ordinateur. Lorsque l'ordinateur envoie une commande d'actionnement à une étape 44, une étape 45 permet de vérifier que le module de contrôle et/ou l'appareil électrique associé à bien reçu et exécute la commande. Une étape 46 effectue l'association dans le superviseur de la dite entrée ou sortie actionnée ou du bloc contact correspondant à un type d'appareil préenregistré dans une table dudit superviseur. Ensuite une étape 47 mémorise l'actionnement du module de contrôle et d'attributs d'identification.

Selon un premier mode de réalisation particulier de l'invention, le procédé comporte une étape 48 d'édition de rapport de test comprenant l'ensemble des actionnements des modules de contrôle et des attributs d'identification. Selon un second mode de réalisation particulier de l'invention le procédé comporte une étape 49 d'édition de schémas électriques comprenant l'ensemble des actionnements des modules de contrôle et des attributs d'identification.

Une étape 50 permet d'enregistrer et d'archiver les détails et caractéristiques de l'installation.

Lors de l'installation et du test les concentrateurs peuvent communiquer avec un superviseur faisant partie de l'installation ou avec un ordinateur temporairement relié au réseau par exemple ordinateur portable. Dans ce dernier cas, les données sont enregistrées ensuite dans le superviseur pour assurer le fonctionnement de l'installation.

## Revendications

1. Dispositif de contrôle d'appareil (19, 20) ou d'installation électrique comportant au moins un module de contrôle comprenant un connecteur pour connecter au moins une entrée ou une sortie, ledit module de contrôle comportant au moins un circuit interrupteur interne connecté à ladite au moins une entrée ou sortie,
**caractérisé en ce qu'**il comporte un concentrateur (9) comportant des connecteurs (10, 10A, 10B, 10C) d'entrées-sorties pour connecter des entrées-sorties audit au moins un module de contrôle (1, 2, 3, 38), des moyens de traitement (11) pour traiter des informations desdites entrées-sotties et un circuit de communication (12) pour communiquer des données relatives audites entrées-sorties, ledit circuit de traitement (11) pouvant traiter ou reporter des états de chaque entrées-sorties dudit concentrateur (9),
au moins un module de contrôle (1, 2) étant associé à un appareil électrique modulaire (19, 20) pour transmettre des états dudit appareil électrique vers le concentrateur (9) ou pour recevoir des commandes d'actionnement pour actionner ledit appareil électrique depuis ledit concentrateur,
lesdits connecteurs (10, 10A, 10B, 10C) d'entrées-sorties dudit concentrateur (9) étant destinés à être connectés à un connecteur (4A, 4B, 4C) d'au moins un module de contrôle (1, 2, 3, 38) par une liaison comportant une ligne de référence (0), une ligne d'alimentation (14), et au moins une ligne d'entrée (15, 16) ou de sortie (17).

2. Dispositif selon la revendication 1 **caractérisé en ce qu'**un connecteur (4, 4A, 4B, 4C) dudit module de contrôle (1, 2, 3, 38) et les connecteurs (10, 10A, 10B, 10C) dudit concentrateur (9) sont des connecteurs standards de même type,

3. Dispositif selon l'une des revendications 1 ou 2 **caractérisé en ce qu'**il comporte au moins une liaison électrique (13) entre un connecteur (4A, 4B, 4C) d'au moins un module de contrôle (1, 2, 3, 38) et un connecteur d'entrées-sorties (10, 10A, 10B, 10C) dudit concentrateur (9), ladite liaison comportant une ligne de référence (0), une ligne d'alimentation (14), une première ligne d'entrée (15) d'un connecteur de concentrateur, une seconde ligne d'entrée (16) dudit connecteur de concentrateur, et une ligne de sortie (17) dudit connecteur de concentreur.

4. Dispositif selon l'une quelconque des revendications 1 à 3 **caractérisé en ce qu'**au moins un module de contrôle (3) est un module de contrôle autonome pour transmettre des états ou des informations d'état de capteurs de grandeurs physiques internes ou externes audit module.

5. Dispositif selon la revendication 4 **caractérisé en ce que** ledit module de contrôle autonome (3) comporte des moyens de mesure et de calcul d'énergie électrique pour émettre des impulsions représentatives d'énergie électrique, lesdites impulsions étant réalisées par la fermeture d'un circuit (8) entre une ligne commune (0) ou d'alimentation (14) et une ligne d'entrée (15, 16) d'un connecteur d'entrées-sorties dudit concentrateur (9).

6. Dispositif selon la revendication 5 **caractérisé en ce que** ledit circuit de traitement (11) du concentrateur (9) reçoit des impulsions et convertit un nombre d'impulsions par unité de temps en valeur d'énergie électrique à transmettre sur le réseau.

7. Dispositif selon l'une quelconque des revendications 1 à 6 **caractérisé en ce que** le concentrateur (9) a une forme allongée et est destiné à être intercalé entre des rangées de supports (32) en forme de rail pour appareillages modulaires.

8. Dispositif selon l'une quelconque des revendications 1 à 7 **caractérisé en ce qu'**il comprend des moyens supports (33) pour supporter ledit concentrateur (9), lesdits moyens supports étant destinés à être fixés sur des rails (32) de support d'appareillage électrique modulaire.

9. Dispositif selon l'une quelconque des revendications 1 à 8 **caractérisé en ce que** le concentrateur (9) comporte des moyens d'adressage (27) et des moyens d'identification de chaque entrée sortie des connecteurs du concentrateur.

10. Installation électrique comportant au moins un tableau ou une armoire électrique (30), au moins un appareil électrique (19, 20), au moins un module de contrôle (1, 2, 3), **caractérisé en ce qu'**elle comprend au moins un dispositif de contrôle selon l'une des revendications 1 à 9 comportant au moins un concentrateur (9) sur lequel sont connectés des modules de contrôle (1, 2, 3, 38).

11. Installation électrique selon la revendication 10 **caractérisé en ce qu'**elle comprend un superviseur (34) connecté en réseau (29) avec au moins un concentrateur (9).

12. Procédé de contrôle d'appareil ou d'installation électrique comportant au moins un dispositif de contrôle selon l'une des revendications 1 à 9, au moins un module de contrôle, au moins un concentrateur, et un superviseur ou un ordinateur local, **caractérisé en ce qu'**il comporte une phase de test comportant :
- l'actionnement (42) d'un module de contrôle,
- l'élaboration (43) et l'envoi d'une trame de communication par le concentrateur comportant l'identification
- de l'adresse du concentrateur,
- d'un bloc contact du concentrateur,
- d'une l'entrée ou d'une sortie dudit bloc contact, et
- de l'état ou du changement d'état de ladite entrée ou sortie,
- l'association (46) dans le superviseur ou ordinateur local de la dite entrée ou sortie actionnée ou du bloc contact correspondant à un type d'appareil préenregistré dans une table dudit superviseur ou ordinateur local, et
- la mémorisation (47) de l'actionnement du module de contrôle et d'attributs d'identification.

13. Procédé selon la revendication 12 **caractérisé en ce qu'**il comporte l'édition (48) de rapport de test comprenant l'ensemble des actionnements des modules de contrôle et des attributs d'identification.

14. Procédé selon l'une des revendications 12 ou 13 **caractérisé en ce qu'**il comporte l'édition (49) de schémas électriques comprenant l'ensemble des actionnements des modules de contrôle et des attributs d'identification.

## Patentansprüche

1. Vorrichtung zur Kontrolle eines Geräts (19, 20) oder einer elektrische Anlage, die mindestens ein Kontrollmodul aufweist, das einen Verbinder enthält, um mindestens einen Eingang oder einen Ausgang zu verbinden, wobei das Kontrollmodul mindestens einen inneren Schaltkreis aufweist, der mit dem mindestens einen Eingang oder Ausgang verbunden ist,
**dadurch gekennzeichnet, dass** sie einen Konzentrator (9), der Verbinder (10, 10A, 10B, 10C) von Eingängen-Ausgängen aufweist, um Eingänge-Ausgänge mit dem mindestens einen Kontrollmodul (1, 2, 3, 38) zu verbinden, Verarbeitungseinrichtungen (11), um Informationen der Eingänge-Ausgänge zu verarbeiten, und einen Kommunikationsschaltkreis (12) aufweist, um Daten bezüglich der Eingänge-Ausgänge zu übertragen, wobei der Verarbeitungsschaltkreis (11) Zustände jedes der Eingänge-Ausgänge des Konzentrators (9) verarbeiten oder verschieben kann,
wobei mindestens ein Kontrollmodul (1, 2) einem modularen elektrischen Gerät (19, 20) zugeordnet ist, um Zustände des elektrischen Geräts zum Konzentrator (9) zu übertragen oder um Betätigungsbefehle zu empfangen, um das elektrische Gerät ausgehend vom Konzentrator zu betätigen,
wobei die Verbinder (10, 10A, 10B, 10C) von Eingängen-Ausgängen des Konzentrators (9) dazu bestimmt sind, mit einem Verbinder (4A, 4B, 4C) mindestens eines Kontrollmoduls (1, 2, 3, 38) durch eine Verbindung verbunden zu werden, die eine Bezugsleitung (0), eine Speiseleitung (14), und mindestens eine Eingangs- (15, 16) oder Ausgangsleitung (17) aufweist.

2. Vorrichtung nach Anspruch 1, **dadurch gekennzeichnet, dass** ein Verbinder (4, 4A, 4B, 4C) des Kontrollmoduls (1, 2, 3, 38) und die Verbinder (10, 10A, 10B, 10C) des Konzentrator (9) Standard-Verbinder des gleichen Typs sind.

3. Vorrichtung nach einem der Ansprüche 1 oder 2, **dadurch gekennzeichnet, dass** sie mindestens eine elektrische Verbindung (13) zwischen einem Verbinder (4A, 4B, 4C) mindestens eines Kontrollmoduls (1, 2, 3, 38) und einem Verbinder von Eingängen-Ausgängen (10, 10A, 10B, 10C) des Konzentrators (9) aufweist, wobei die Verbindung eine Bezugsleitung (0), eine Speiseleitung (14), eine erste Eingangsleitung (15) eines Konzentratorverbinders, eine zweite Eingangsleitung (16) des Konzentratorverbinders und eine Ausgangsleitung (17) des Konzentratorverbinders aufweist.

4. Vorrichtung nach einem der Ansprüche 1 bis 3, **dadurch gekennzeichnet, dass** mindestens ein Kontrollmodul (3) ein autonomes Kontrollmodul ist, um Zustände oder Zustandsinformationen von Sensoren physikalischer Größen innerhalb oder außerhalb des Moduls zu übertragen.

5. Vorrichtung nach Anspruch 4, **dadurch gekennzeichnet, dass** das autonome Kontrollmodul (3) Mess- und Recheneinrichtungen elektrischer Energie aufweist, um für elektrische Energie repräsentative Impulse zu senden, wobei die Impulse durch das Schließen eines Schaltkreises (8) zwischen einer gemeinsamen Leitung (0) oder Speiseleitung (14) und einer Eingangsleitung (15, 16) eines Verbinders von Eingängen-Ausgängen des Konzentrators (9) hergestellt werden.

6. Vorrichtung nach Anspruch 5, **dadurch gekennzeichnet, dass** der Verarbeitungsschaltkreis (11) des Konzentrators (9) Impulse empfängt und eine Anzahl von Impulsen pro Zeiteinheit in einen elektrischen Energiewert umwandelt, der im Netz zu übertragen ist.

7. Vorrichtung nach einem der Ansprüche 1 bis 6, **dadurch gekennzeichnet, dass** der Konzentrator (9) eine längliche Form hat und dazu bestimmt ist, zwischen Reihen von schienenförmigen Trägern (32) für modulare Geräte eingeschoben zu werden.

8. Vorrichtung nach einem der Ansprüche 1 bis 7, **dadurch gekennzeichnet, dass** sie Trägereinrichtungen (33) enthält, um den Konzentrator (9) zu tragen, wobei die Trägereinrichtungen dazu bestimmt sind, an Trägerschienen (32) eines modularen elektrischen Geräts befestigt zu werden.

9. Vorrichtung nach einem der Ansprüche 1 bis 8, **dadurch gekennzeichnet, dass** der Konzentrator (9) Adressiereinrichtungen (27) und Erkennungseinrichtungen jedes Eingangs-Ausgangs der Verbinder des Konzentrators aufweist.

10. Elektrische Anlage, die mindestens eine Schalttafel oder einen Elektroschrank (30), mindestens ein elektrisches Gerät (19, 20), mindestens ein Kontrollmodul (1, 2, 3) aufweist, **dadurch gekennzeichnet, dass** sie mindestens eine Kontrollvorrichtung nach einem der Ansprüche 1 bis 9 aufweist, die mindestens einen Konzentrator (9) aufweist, mit dem Kontrollmodule (1, 2, 3, 38) verbunden sind.

11. Elektrische Anlage nach Anspruch 10, **dadurch gekennzeichnet, dass** sie einen Supervisor (34) enthält, der im Netz (29) mit mindestens einem Konzentrator (9) verbunden ist.

12. Verfahren zur Kontrolle eines Geräts oder einer elektrischen Anlage, das/die mindestens eine Kontrollvorrichtung nach einem der Ansprüche 1 bis 9, mindestens ein Kontrollmodul, mindestens einen Konzentrator und einen Supervisor oder einen lokalen Computer aufweist, **dadurch gekennzeichnet, dass** es eine Testphase aufweist, die aufweist:
- die Betätigung (42) eines Kontrollmoduls,
- die Erarbeitung (43) und das Senden eines Kommunikationsrahmens durch den Konzentrator, der die Erkennung
- der Adresse des Konzentrators,
- eines Kontaktblocks des Konzentrators,
- eines Eingangs oder eines Ausgangs des Kontaktblocks und
- des Zustands oder der Zustandsänderung des Eingangs oder Ausgangs aufweist,
- die Zuordnung (46) im Supervisor oder lokalen Computer des betätigten Eingangs oder Ausgangs oder des Kontaktblocks entsprechend einer Art von Gerät, die in einer Tabelle des Supervisors oder lokalen Computers vorab gespeichert wird, und
- die Speicherung (47) der Betätigung des Kontrollmoduls und von Erkennungsattributen.

13. Verfahren nach Anspruch 12, **dadurch gekennzeichnet, dass** es die Ausgabe (48) eines Testprotokolls aufweist, das die Gesamtheit der Betätigungen der Kontrollmodule und der Erkennungsattribute enthält.

14. Verfahren nach einem der Ansprüche 12 oder 13, **dadurch gekennzeichnet, dass** es die Ausgabe (49) von elektrischen Schaltbildern aufweist, die die Gesamtheit der Betätigungen der Kontrollmodule und der Erkennungsattribute enthalten.

## Claims

1. Device for monitoring an electric unit (19, 20) or installation comprising at least one monitoring module having a connector for connecting at least one input or one output, said monitoring module comprising at least one internal switch circuit connected to said at least one input or output, **characterized in that** it comprises a hub (9) comprising input/output connectors (10, 10A, 10B, 10C) for connecting inputs/outputs to said at least one monitoring module (1, 2, 3, 38), processing means (11) for processing information from said inputs/outputs, and a communication circuit (12) for communicating data relating to said inputs/outputs, said processing circuit (11) being able to process or report states of each of the inputs/outputs of said hub (9), at least one monitoring module (1, 2) being associated with a modular electric unit (19, 20) for transmitting states of said electric unit to the hub (9) or for receiving actuation commands for actuating said electric unit from said hub, said input/output connectors (10, 10A, 10B, 10C) of said hub (9) being intended to be connected to a connector (4A, 4B, 4C) of at least one monitoring module (1, 2, 3, 38) by means of a link comprising a reference line (0), a power supply line (14), and at least one input line (15, 16) or output line (17).

2. Device according to Claim 1, **characterized in that** a connector (4, 4A, 4B, 4C) of said monitoring module (1, 2, 3, 38) and the connectors (10, 10A, 10B, 10C) of said hub (9) are standard connectors of the same type.

3. Device according to either of Claims 1 and 2, **characterized in that** it comprises at least one electric link (13) between a connector (4A, 4B, 4C) of at least one monitoring module (1, 2, 3, 38) and an input/output connector (10, 10A, 10B, 10C) of said hub (9), said link comprising a reference line (0), a power supply line (14), a first input line (15) of a hub connector, a second input line (16) of said hub connector, and an output line (17) of said hub connector.

4. Device according to any one of Claims 1 to 3, **characterized in that** at least one monitoring module (3) is an autonomous monitoring module for transmitting states or state information from internal or external physical value sensors to said module.

5. Device according to Claim 4, **characterized in that** said autonomous monitoring module (3) comprises means for measuring and calculating electric power for emitting pulses representative of electric power, said pulses being created by closing a circuit (8) between a common line (0) or power supply line (14) and an input line (15, 16) of an input/output connector of said hub (9).

6. Device according to Claim 5, **characterized in that** said processing circuit (11) of the hub (9) receives pulses and converts a number of pulses per unit time into an electric power value to be transmitted on the network.

7. Device according to any one of Claims 1 to 6, **characterized in that** the hub (9) has an elongated shape and is intended to be inserted between rows of supports (32) in the form of rails for modular apparatus.

8. Device according to any one of Claims 1 to 7, **characterized in that** it has support means (33) for supporting said hub (9), said support means being intended to be fastened on rails (32) for supporting modular electric apparatus.

9. Device according to any one of Claims 1 to 8, **characterized in that** the hub (9) comprises means (27) for addressing and means for identifying each input/output of the connectors of the hub.

10. Electric installation comprising at least one electrical switchboard or enclosure (30), at least one electric unit (19, 20) and at least one monitoring module (1, 2, 3), **characterized in that** it comprises at least one monitoring device according to one of Claims 1 to 9 comprising at least one hub (9) to which monitoring modules (1, 2, 3, 38) are connected.

11. Electric installation according to Claim 10, **characterized in that** it has a supervisor (34) connected in a network (29) with at least one hub (9).

12. Method for monitoring an electric unit or installation comprising at least one monitoring device according to one of Claims 1 to 9, at least one monitoring module, at least one hub, and a supervisor or a local computer, **characterized in that** it comprises a test phase comprising:
- the actuation (42) of a monitoring module,
- the generation (43) and sending of a communication frame by the hub, comprising the identification
- of the address of the hub,
- of a contact block of the hub,
- of an input or of an output of said contact block, and
- of the state or of the change in state of said input or output,
- the association (46), in the supervisor or local computer, of said actuated input or output or of the corresponding contact block with a unit type pre-recorded in a table of said supervisor or local computer, and
- the storage (47) of the actuation of the monitoring module and of identification attributes.

13. Method according to Claim 12, **characterized in that** it comprises the publication (48) of a test report containing all of the actuations of the monitoring modules and the identification attributes.

14. Method according to either of Claims 12 and 13, **characterized in that** it comprises the publication (49) of circuit diagrams containing all of the actuations of the monitoring modules and the identification attributes.
